# EUROPÄISCHE PATENTSCHRIFT

(11) **EP 2 142 681 B1**
(45) Veröffentlichungstag und Bekanntmachung des Hinweises auf die Patenterteilung: **22.08.2012**
(21) Anmeldenummer: 08757988.4
(22) Anmeldetag: 21.04.2008
(51) Int. Cl.: C23C 14/32, C23C 14/56, H01J 37/32

(54) **ANORDNUNG ZUR AUSBILDUNG VON BESCHICHTUNGEN AUF SUBSTRATEN IM VAKUUM**
ARRANGEMENT FOR PRODUCING COATINGS ON SUBSTRATES IN VACUO
ENSEMBLE PERMETTANT DE RÉALISER DES REVÊTEMENTS SUR DES SUBSTRATS SOUS VIDE

(30) Priorität: 23.04.2007 DE 102007019982
(43) Veröffentlichungstag der Anmeldung: 13.01.2010
(73) Patentinhaber: Fraunhofer-Gesellschaft zur Förderung der angewandten Forschung e.V., 80686 München (DE)
(72) Erfinder: MEYER, Carl-Friedrich, 01328 Dresden (DE)
(74) Vertreter: Pfenning, Meinig & Partner GbR
(86) Internationale Anmeldenummer: PCT/DE2008/000727
(87) Internationale Veröffentlichungsnummer: WO 2008/128535

(56) Entgegenhaltungen:
- DE-A1- 10 319 205
- DE-A1- 19 816 818
- BOXMAN R L ET AL: "Vacuum arc deposition devices" REVIEW OF SCIENTIFIC INSTRUMENTS 2006 AMERICAN INSTITUTE OF PHYSICS INC. US, Bd. 77, Nr. 2, 2006, Seiten 021101-1-021101-15, XP002504726
- COLL B F ET AL: "Design of vacuum arc-based sources" SURFACE AND COATINGS TECHNOLOGY, ELSEVIER, AMSTERDAM, NL, Bd. 81, Nr. 1, 1. Januar 1996 (1996-01-01), Seiten 42-51, XP002124098 ISSN: 0257-8972

## Beschreibung

Die Erfindung betrifft eine Anordnung zur Ausbildung von Beschichtungen auf Substraten im Vakuum, bei der ein Plasma mittels elektrischer Bogenentladung an mindestens einem als Kathode geschalteten Target gebildet und die Bogenentladung zwischen einer Anode und dem Target mittels eines auslenkbaren fokussierten Laserstrahls, der auf die Oberfläche des Targets gerichtet ist, gezündet wird. Der von einer außerhalb einer Vakuumkammer angeordneten Laserlichtquelle emittierte Laserstrahl wird dabei durch ein an der Vakuumkammer vorhandenes Fenster in die Vakuumkammer und so auf die Oberfläche des jeweiligen Targets gerichtet.

So können Bogenentladungen ausgehend von der Oberfläche eines Targets an unterschiedlichen Positionen gezündet werden, um einen gleichmäßigen Werkstoffabtrag über eine nutzbare Oberfläche eines Targets erreichen zu können. So können innerhalb von Vakuumkammern angeordnete Targets über längere Betriebsdauern eingesetzt und dabei eine gleichmäßige Beschichtungsbildung erreicht werden.

Die Auslenkung eines solchen Laserstrahls kann über herkömmliche Systeme, beispielsweise Scannersysteme oder andere geeignete und bewegliche reflektierende Elemente erreicht werden.

Eine solche technische Lösung ist unter anderem in DE 19850217 C1 beschrieben und die dem gemäße Verfahrensweise wird auch als "Laser-Arc-Verfahren" bezeichnet.

Dabei kann es aber nicht vermieden werden, dass bestimmte Teile des gebildeten Plasmas innerhalb der Vakuumkammer vagabundieren und es infolge dessen auch zu einer Absetzung von Beschichtungswerkstoff innerhalb der Vakuumkammer und dementsprechend auch an solchen Fenstern kommen kann. Die Fenster werden also ebenfalls mit einer Schicht versehen. Dadurch reduziert sich in unerwünschter Form die Transparenz der Fenster, so dass diese mehr oder weniger häufig gereinigt oder gar ausgetauscht werden müssen. Um diesen Nachteilen entgegenzuwirken, wurden auch Fensterschutzfolien eingesetzt, die in der Vakuumkammer angeordnet sind und demzufolge die Fenster vor einer Beschichtung schützen, aber selbstverständlich auch beschichtet werden. Solche Fensterschutzfolien sind als Rollen verfügbar und werden beim Betrieb einer entsprechenden Beschichtungsanlage von einer Vorratsrolle abgerollt und auf eine zweite Rolle aufgerollt, wobei dies beim Betrieb einer Anlage sukzessive oder kontinuierlich durchgeführt wird. Der Rollvorgang wird dabei mit einer Geschwindigkeit von zirka zwei Meter pro Stunde durchgeführt. Der Vorrat einer solchen Folie innerhalb einer Vakuumkammer ist aber dadurch begrenzt, dass Wasser und andere Gase innerhalb einer Folienrolle enthalten sind, die ausgasen können und die Vakuumbedingungen unerwünscht beeinflussen. Dementsprechend ist ein Austausch einer Rolle nach zirka 15 Betriebsstunden erforderlich. Durch die für den Austausch erforderliche Zeit und auch die Kosten für die Fensterschutzfolie erhöhen sich selbstverständlich die Fertigungskosten entsprechend.

So ist in der DE 198 16 818 A1 eine Vakuumbeschichtungsanlage beschrieben, bei der in der Wand einer Quellenkammer ein Vakuumfenster vorhanden ist, durch das ein Laserstrahl mittels einer Ablenkeinheit über die Oberfläche einer Materialquelle geführt wird.

Die DE 103 19 205 A1 betrifft eine Vorrichtung zur Abscheidung partikulatfreier Schichten mittels Laserstrahlen. Es ist ein Fenster zur Einkopplung der Laserstrahlen vorhanden.

Es ist daher Aufgabe der Erfindung eine technische Lösung vorzugeben, mit der eine unerwünschte Beschichtung im Fensterbereich deutlich reduziert werden kann.

Erfindungsgemäß wird diese Aufgabe mit einer Anordnung, die die Merkmale des Anspruchs 1 aufweist gelöst. Vorteilhafte Ausgestaltungsformen und Weiterbildungen der Erfindung können mit in den untergeordneten Ansprüchen bezeichneten Merkmalen erreicht werden.

Eine erfindungsgemäße Anordnung zur Ausbildung von Beschichtungen auf Substraten im Vakuum, bei der mit dem "Laser-Arc-Verfahren" wie es aus dem Stand der Technik bekannt ist gearbeitet werden kann, ist dadurch weitergebildet, dass zwischen Fenster und mindestens einem Target mindestens ein Permanent- oder Elektromagnet angeordnet ist. Mindestens ein Permanent- oder Elektromagnet ist dabei seitlich neben oder ober- bzw. unterhalb der optischen Achse des Laserstrahls angeordnet und vom Permanent- oder Elektromagnet wird dabei eine magnetisches Feld ausgebildet. Durch das magnetische Feld kann der Laserstrahl in Richtung auf die Oberfläche des Targets gerichtet werden.

Das von einem oder mehreren Permanent- oder Elektromagnet(en) jeweils ausgebildete magnetische Feld sollte eine Feldkomponente aufweisen, die senkrecht zur optischen Achse des Laserstrahls und/oder der Ebene in der der Laserstrahl ausgelenkt wird ausgerichtet ist.

Der Laserstrahl kann, wie bereits im einleitenden Teil der Beschreibung ausgeführt, ausgelenkt werden, wobei dies bevorzugt durch eine oszillierende Bewegung zwischen Umkehrpunkten in einer Ebene durchgeführt werden kann. Dementsprechend sollte ein Fenster an der Vakuumkammer eine entsprechende Gestalt und Dimensionierung aufweisen, mit der gewährleistet werden kann, dass der Laserstrahl bei der Auslenkung die gesamte Länge von Targets überstreichen kann.

Für einen verbesserten Schutz kann innerhalb der Vakuumkammer zwischen Fenster und Permanent- oder Elektromagnet(en) eine Blende angeordnet sein, durch deren Öffnung der Laserstrahl für die Zündung von Bogenentladungen hindurchgeführt werden kann.

In einer Weiterbildung der Erfindung kann, wie dies aus dem Stand der Technik bekannt ist, eine Fensterschutzfolie vor dem Fenster, bevorzugt zwischen Blende und Fenster, angeordnet sein, die ebenfalls in an sich bekannter Weise von einer Vorratsrolle ab auf eine weitere Rolle aufgerollt werden kann.

Mit dem/den Magnetfeld(ern) kann Plasma und auch Targetwerkstoff so abgelenkt werden, dass es nicht in Richtung Fenster bzw. Fensterschutzfolie gelangen kann, wodurch dort die Beschichtung in diesem Bereich zumindest erheblich reduziert werden kann.

Der Schutz vor unerwünschter Beschichtung kann auch dadurch erhöht werden, dass neben der bereits erwähnten Blende eine zweite Blende innerhalb der Vakuumkammer angeordnet ist.

Dabei kann eine zweite Blende als gesonderte Blende mit einer Öffnung, durch die der Laserstrahl für die Zündung von Bogenentladungen auf das Target gerichtet werden kann, zwischen Target und der ersten Blende bzw. Fensterschutzfolie oder Fenster angeordnet sein. Eine solche Blende ist dabei dann in unmittelbarer Nähe von Targets angeordnet.

In einer anderen erfindungsgemäßen Alternative kann eine solche Blende auch mit entsprechender Anordnung von mindestens zwei Permanent- oder Elektromagneten ausgebildet sein; die dann so angeordnet sind, dass sie einen Spalt bilden, der quasi eine Öffnung einer Blende bilden kann. So können zwei Permanent- oder Elektromagnete so angeordnet sein, dass ein Permanent- oder Elektromagnet an einer Seite der optischen Achse und ein zweiter Permanent- oder Elektromagnet auf einer gegenüberliegenden Seite der optischen Achse des Laserstrahls angeordnet sind. Sie können dabei parallel zueinander ausgerichtet sein.

Bei der Erfindung sollten die Permanent- oder Elektromagnete so angeordnet sein, dass sie eine jeweils gleiche Polausrichtung aufweisen.

Dabei besteht die Möglichkeit, mindestens zwei Permanent- oder Elektromagnete in einer versetzten Anordnung zwischen Fenster und Target anzuordnen, so dass sie jeweils unterschiedliche Abstände zum Target oder auch zum Fenster aufweisen.

Günstig ist es außerdem, dass die bei der erfindungsgemäßen Anordnung einsetzbaren einzelnen Elemente, nämlich die Blenden und Permanent- oder Elektromagnete unter Berücksichtigung der Dimensionierung von Targets angeordnet und ausgebildet sind.

Bei der Erfindung ist es nämlich möglich lediglich ein einziges Target einzusetzen, von dem Plasma für eine Beschichtung von Substraten gebildet werden kann. In anderer Alternative können aber auch mehrere Targets, bevorzugt in einer Reihenanordnung vorgesehen werden. Mit mehreren solcher Targets können dann Mehrschichtsysteme auf Substraten ausgebildet werden, in dem Targets aus unterschiedlichen Stoffen oder Stoffgemischen eingesetzt werden.

Targets können dabei walzen- oder zylinderförmig ausgebildet sein und um eine Achse während der Ausbildung von Beschichtungen rotieren, wodurch ein gleichmäßiger Abtrag von Targetwerkstoff bei der Plasmabildung weiter unterstützt werden kann.

Wie bereits angedeutet sollten dann die Längen von Blenden und auch die Breite von erfindungsgemäß eingesetzten Permanent- oder Elektromagneten die jeweilige Targetlänge berücksichtigen. Dementsprechend sollten die Blendenöffnungen oder die Breiten von Permanent- oder Elektromagneten zumindest der Länge eines Targets oder der Gesamtlänge mehrerer in Reihe angeordneter Targets entsprechen, so dass ein Laserstrahl über die gesamte Länge eines oder mehrerer Targets ausgelenkt und ein Schutz vor unerwünschter Beschichtung erreicht werden kann.

Wie bereits angesprochen kann der Laserstrahl in einer Ebene hin- und herbewegt und so ausgelenkt werden. In diesem Fall liegt die optische Achse des Laserstrahls in der Ebene, in der die Auslenkung durchgeführt wird.

Nachfolgend soll die Erfindung beispielhaft näher erläutert werden. Dabei zeigen:
- Figur 1: in schematischer Form ein Beispiel einer erfindungsgemäßen Anordnung;
- Figur 2: eine Seitenansicht eines Beispiels einer erfindungsgemäßen Anordnung und
- Figur 3: ein weiteres Beispiel einer erfindungsgemäßen Anordnung.

In den Figuren wurde auf die Darstellung einer Vakuumkammer und ein daran ausgebildetes Fenster, durch das ein Laserstrahl 5 in die Vakuumkammer in Richtung auf ein Target 6 gerichtet werden kann, verzichtet.

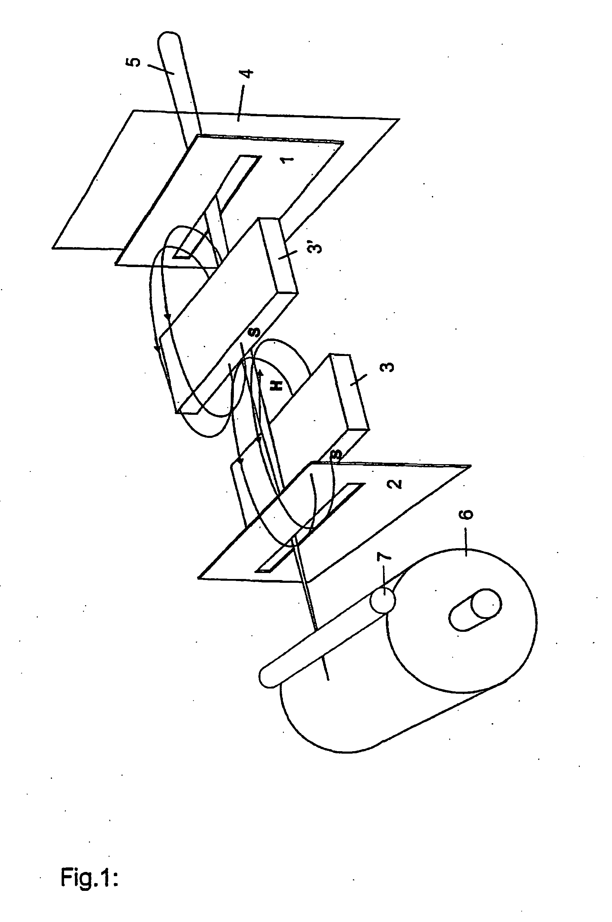

Die Figur 1 zeigt, wie ein Laserstrahl 5 von einer außerhalb einer Vakuumkammer angeordneten Laserlichtquelle durch ein Fenster und eine Fensterschutzfolie 4, die Öffnung einer Blende 1 und eine weitere Öffnung einer zweiten Blende 2 in Richtung auf ein Target 6 gerichtet werden kann. Die Öffnungen der Blenden 1 und 2 sind dabei in rechteckiger Form ausgebildet und weisen eine ausreichend große Länge auf, so dass der Laserstrahl 5 über eine Gesamtlänge eines oder mehrerer Targets 6 ausgelenkt werden kann.

Bei dem in Figur 1 gezeigten Beispiel sind zwei Permanentmagnete 3 und 3' zwischen den beiden Blenden 1 und 2 angeordnet. Dabei sind der Permanentmagnet 3 unterhalb der optischen Achse des Laserstrahls 5 und der Permanentmagnet oberhalb der optischen Achse des Laserstrahls 5 angeordnet. Der Laserstrahl 5 kann so zwischen den beiden Permanentmagneten 3 und 3' hindurch in Richtung auf das Target 6 gerichtet werden. Die Blende 1 hat eine Öffnung, deren Höhe bei 10 mm liegt und sie ist unmittelbar vor der Fensterschutzfolie 4 angeordnet. Die Öffnung der Blende 2 hat eine Höhe von 4 mm und ist dabei unmittelbar vor dem als Kathode geschalteten Target 6 angeordnet.

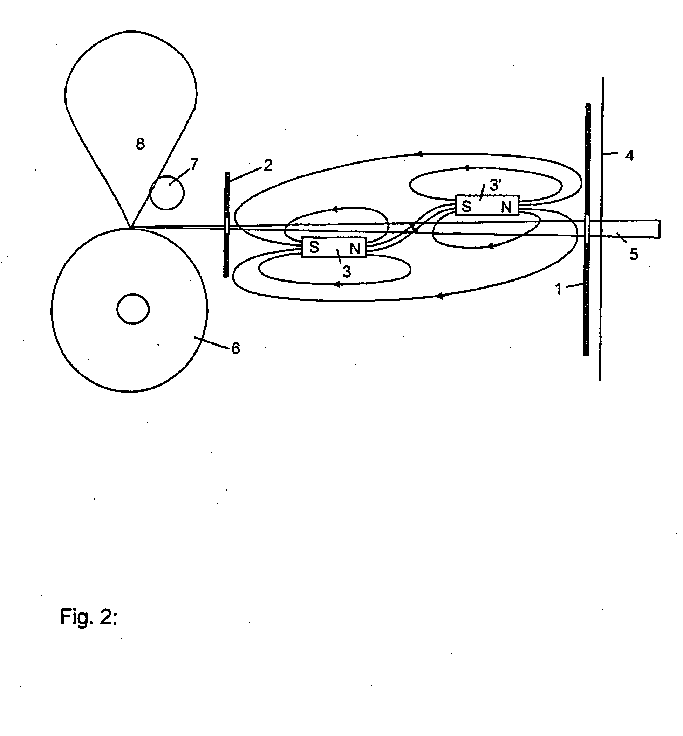

Die beiden Permanentmagnete 3 und 3' sind so angeordnet, dass sie eine gleiche Polausrichtung in Ausbreitungsrichtung des Laserstrahls 5 aufweisen. In schematischer Form sind ebenfalls Feldlinien der Magnetfelder der beiden Permanentmagnete 3 und 3' eingezeichnet, was auch auf die Figur 2 zutrifft.

Die Länge eines Targets 6, das in Walzenform ausgebildet ist, kann bei 200 mm liegen oder es kann auch länger sein. Dementsprechend können auch Permanentmagnete 3 und 3' eingesetzt werden, deren Gesamtlänge zumindest bei der Targetlänge von 200 mm liegt. Dabei besteht aber auch die Möglichkeit, mehrere Permanentmagnete, die dann eine kürzere Länge aufweisen, in einer Reihe anzuordnen und dabei die in Reihe angeordneten Permanentmagnete 3 bzw. 3' eine jeweils gleich Polausrichtung aufweisen. So kann beispielsweise mit vier Permanentmagneten 3 oder 3' mit einer jeweiligen Länge von 70 mm und einer Breite von 15 mm eine Gesamtlänge von 280 mm erreicht werden.

Mit Figur 2 wird außerdem verdeutlicht, wie der Laserstrahl 5 über die Öffnungen der Blenden 1 und 2 und zwischen den Permanentmagneten 3 und 3' auf die Oberfläche eines walzenförmigen Targets 6 gerichtet werden kann. Zwischen dem als Kathode geschalteten Target 6 und einer Anode 7 können so elektrische Bogenentladungen gezündet und damit ein Plasma 8 gebildet werden, das wiederum für die Beschichtung von hier nicht dargestellten Substraten innerhalb einer Vakuumkammer eingesetzt werden kann.

Bei der Erfindung können Permanentmagnete 3 oder 3' eingesetzt werden, die eine magnetische Induktion von 20 bis 50 mT aufweisen.

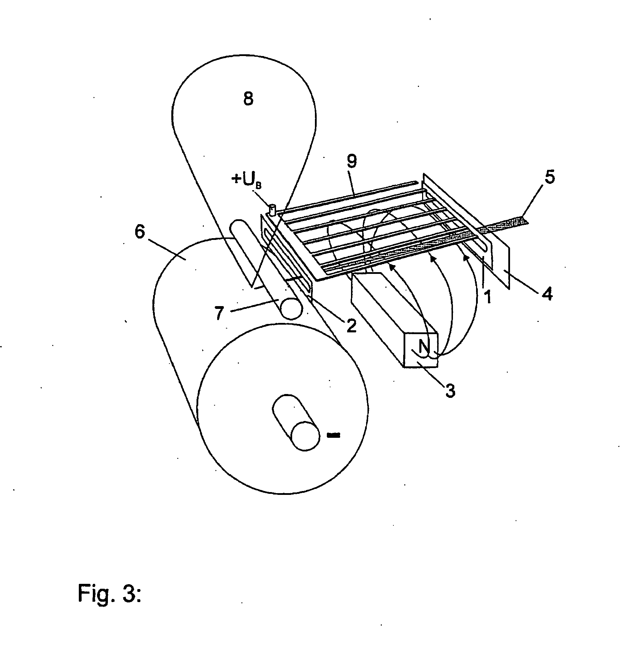

In Figur 3 ist ein weiteres Beispiel einer erfindungsgemäßen Anordnung gezeigt. Dabei ist wieder ein in einer Ebene parallel zur Oberfläche eines walzenförmigen, um seine Längsachse rotierenden Targets 6 auslenkbarer Laserstrahl 5 zum Zünden von elektrischen Bogenentladungen dargestellt, der durch ein hier nicht dargestelltes Fenster, eine Fensterschutzfolie 4, durch Öffnungen der beiden Blenden 1 und 2 auf das Target 6 gerichtet ist.

Hier unterhalb der Ebene in der der Laserstrahl 5 ausgelenkt wird und/oder der optischen Achse eines nicht ausgelenkten Laserstrahls 5 ist ein Permanentmagnet 3 angeordnet. Das Feld, das vom Permanentmagneten 3 ausgebildet ist, ist parallel zur Anode 2 ausgerichtet. Auf der gegenüberliegenden Seite der Ebene oder optischen Achse ist ein Element 9 angeordnet, das ebenfalls, wie auch die Anode 7 elektrisch positiv an eine elektrische Spannungsquelle angeschlossen ist. Mit dem Element 9, insbesondere auch in Verbindung mit dem Feld des Permanentmagneten besonders gut,3 kann durch die Blende 2 hindurch tretendes Plasma 8 oder bei einer Ausführung ohne Blende 2, in diese Richtung gelangendes Plasma 8 zusätzlich so abgelenkt werden, dass eine Beschichtung der Fensterfolie 4 reduziert werden kann.

Das Element 9 kann dabei als einfache Platte eines elektrisch leitenden Werkstoffs ausgebildet sein. Es kann aber auch gitterförmig oder, wie in Figur 3 dargestellt mit Streifen versehen oder ganz streifenförmig ausgebildet sein.

Das Element 9 sollte dabei so angeordnet und auch ausgerichtet sein, dass der Laserstrahl 5 nicht behindert wird, aber ein vom Element 9 gebildetes Magnetfeld seine Wirkung auf in diesen Bereich gelangendes Plasma 8, zu dessen gewünschter Ablenkung von der Fensterfolie 4 weg, ausüben kann.

Das Element 9 kann dabei parallel zur Ebene der Auslenkung oder der optischen Achse des Laserstrahls 5 ausgerichtet sein. Es besteht aber auch die Möglichkeit eine schräge Neigung des Elements 9 mit einem relativ kleinen Neigungswinkel ausgehend von der zum Target 6 gerichteten bis zur in Richtung Blende 1 und Fensterfolie 4 gerichteten Seite des Elements 9 vorzusehen.

## Patentansprüche

1. Anordnung zur Ausbildung von Beschichtungen auf Substraten im Vakuum, bei der ein Plasma mittels elektrischer Bogenentladung an mindestens einem als Kathode geschalteten Target gebildet und die Bogenentladung zwischen einer Anode und dem Target mittels eines auslenkbaren Laserstrahls, der auf die Oberfläche des Targets gerichtet ist, gezündet wird; dabei der Laserstrahl durch ein an einer Vakuumkammer angeordnetes Fenster auf das Target gerichtet ist,
**dadurch gekennzeichnet, dass**
zwischen Fenster und dem/den Target(s) (6) mindestens ein Permanent- oder Elektromagnet (3, 3') seitlich neben, ober- oder unterhalb der optischen Achse des Laserstrahls (5) angeordnet und der Laserstrahl (5) durch ein vom Permanent- oder Elektromagnet (3, 3') ausgebildetes Magnetfeld geführt ist.

2. Anordnung nach Anspruch 1, **dadurch gekennzeichnet, dass** ein von einem oder mehreren Permanent- oder Elektromagnet(en) (3, 3') ausgebildetes magnetisches Feld, eine senkrecht zur optischen Achse des Laserstrahls (5) und/oder der Ebene in der der Laserstrahl (5) ausgelenkt ist ausgerichtete Feldkomponente aufweist.

3. Anordnung nach Anspruch 1 oder 2, **dadurch gekennzeichnet, dass** zwischen Permanent- oder Elektromagnet(en) (3, 3') und Fenster eine erste Blende (1) angeordnet ist, durch deren Öffnung der Laserstrahl (5) auf das/die Target(s) (6) gerichtet ist.

4. Anordnung nach einem der vorhergehenden Ansprüche, **dadurch gekennzeichnet, dass** ein Permanent- oder Elektromagnet (3) an einer Seite der optischen Achse und ein zweiter Permanent- oder Elektromagnet (3') auf einer gegenüberliegenden Seite der optischen Achse des Laserstrahls (5) angeordnet ist.

5. Anordnung nach Anspruch 4, **dadurch gekennzeichnet, dass** die Permanent- oder Elektromagnete (3, 3') die gleiche Polausrichtung aufweisen.

6. Anordnung nach einem der vorhergehenden Ansprüche, **dadurch gekennzeichnet, dass** ein an ein elektrisch positives Potential angeschlossenes Element (9) an einer dem mindestens einen Permanent- oder Elektromagnet (3) gegenüberliegend angeordneten Seite in Bezug zur optischen Achse und/oder der Ebene in der der Laserstrahl (5) ausgelenkt ist, angeordnet ist.

7. Anordnung nach Anspruch 6, **dadurch gekennzeichnet, dass** mit Permanent- oder Elektromagnet (3) ein Feld ausgebildet ist, das parallel zur Längsachse der Anode (7) ausgerichtet ist.

8. Anordnung nach Anspruch 6 oder 7, **dadurch gekennzeichnet, dass** das Element (9) platten-, streifen-, gitterförmig oder mit Streifen versehen ausgebildet und dabei das Element (9) parallel zur optischen Achse des Laserstrahls (5) und/oder der Ebene in der der Laserstrahl (5) ausgelenkt ist ausgerichtet ist.

9. Anordnung nach einem der vorhergehenden Ansprüche, **dadurch gekennzeichnet, dass** die Permanent- oder Elektromagnete (3, 3') in einer versetzten Anordnung zwischen Fenster und Target (6) angeordnet sind.

10. Anordnung nach einem der vorhergehenden Ansprüche, **dadurch gekennzeichnet, dass** zwei Permanent- oder Elektromagnete (3, 3') eine Blende bilden.

11. Anordnung nach einem der vorhergehenden Ansprüche, **dadurch gekennzeichnet, dass** der/die Permanent- oder Elektromagnet(e)(3, 3') eine Breite aufweist/-weisen, die mindestens der Länge des/der Targets (6) entspricht.

12. Anordnung nach einem der vorhergehenden Ansprüche, **dadurch gekennzeichnet, dass** ein oder mehrere Permanent- oder Elektromagnet(e) (3, 3') zwischen zwei Blenden (1, 2) angeordnet ist/sind.

13. Anordnung nach einem der vorhergehenden Ansprüche, **dadurch gekennzeichnet, dass** zwischen der ersten Blende (1) und dem Fenster eine Fensterschutzfolie (4) angeordnet ist.

14. Anordnung nach dem vorhergehenden Anspruch, **dadurch gekennzeichnet, dass** die Fensterschutzfolie (4) mittels eines Mechanismus auf- und abrollbar ist.

## Claims

1. An arrangement for forming coatings on substrates in a vacuum, in which a plasma is formed by means of electric arc discharge on at least one target which is connected as a cathode, and the arc discharge is ignited between an anode and the target by means of a deflectable laser beam which is directed at the surface of the target; the laser beam is directed onto the target through a window arranged on a vacuum chamber, **characterised in that** between the window and the target(s) (6) at least one permanent magnet or electromagnet (3, 3') is arranged laterally next to, above or below the optical axis of the laser beam (5), and the laser beam (5) is guided through a magnetic field formed by the permanent magnet or electromagnet (3, 3').

2. An arrangement according to Claim 1, **characterised in that** a magnetic field formed by one or more permanent magnet(s) or electromagnet(s) (3, 3') has a field component oriented perpendicular to the optical axis of the laser beam (5) and/or to the plane in which the laser beam (5) is deflected.

3. An arrangement according to Claim 1 or 2, **characterised in that** a first aperture (1) is arranged between the permanent magnet(s) or electromagnet(s) (3, 3') and the window, through the opening in which aperture the laser beam (5) is directed at the target(s) (6).

4. An arrangement according to one of the preceding claims, **characterised in that** one permanent magnet or electromagnet (3) is arranged on one side of the optical axis and a second permanent magnet or electromagnet (3') is arranged on an opposing side of the optical axis of the laser beam (5).

5. An arrangement according to Claim 4, **characterised in that** the permanent magnets or electromagnets (3, 3') have the same pole orientation.

6. An arrangement according to one of the preceding claims, **characterised in that** an element (9) connected to an electrically positive potential is arranged on a side arranged opposite the at least one permanent magnet or electromagnet (3) in relation to the optical axis and/or the plane in which the laser beam (5) is deflected.

7. An arrangement according to Claim 6, **characterised in that** a field which is oriented parallel to the longitudinal axis of the anode (7) is formed with the permanent magnet or electromagnet (3).

8. An arrangement according to Claim 6 or 7, **characterised in that** the element (9) is plate-shaped, strip-shaped, grid-shaped or formed provided with strips, and in such case the element (9) is oriented parallel to the optical axis of the laser beam (5) and/or to the plane in which the laser beam (5) is deflected.

9. An arrangement according to one of the preceding claims, **characterised in that** the permanent magnets or electromagnets (3, 3') are arranged in an offset arrangement between the window and the target (6).

10. An arrangement according to one of the preceding claims, **characterised in that** two permanent magnets or electromagnets (3, 3') form an aperture.

11. An arrangement according to one of the preceding claims, **characterised in that** the permanent magnet(s) or electromagnet(s) (3, 3') has/have a width which corresponds to at least the length of the target (6).

12. An arrangement according to one of the preceding claims, **characterised in that** one or more permanent magnet(s) or electromagnet(s) (3, 3') is/are arranged between two apertures (1, 2).

13. An arrangement according to one of the preceding claims, **characterised in that** a window protection film (4) is arranged between the first aperture (1) and the window.

14. An arrangement according to the preceding claim, **characterised in that** the window protection film (4) can be rolled up and unrolled by means of a mechanism.

## Revendications

1. Agencement pour la formation de revêtements sur des substrats sous vide, dans lequel un plasma est formé au moyen d'une décharge en arc électrique sur au moins une cible connectée en tant que cathode et la décharge en arc est allumée entre une anode et la cible au moyen d'un faisceau laser déviable, qui est orienté vers la surface de la cible ; dans lequel le faisceau laser est orienté vers la cible au travers d'une fenêtre agencée sur une chambre à vide,
**caractérisé en ce qu'**au moins un aimant permanent ou un électro-aimant (3, 3') est agencé latéralement entre la fenêtre et la ou les cibles (6) à côté, au-dessus ou en dessous de l'axe optique du faisceau laser (5) et le faisceau laser (5) est mené au travers d'un champ magnétique créé par l'aimant permanent ou l'électro-aimant (3, 3').

2. Agencement selon la revendication 1, **caractérisé en ce qu'**un champ magnétique formé par un ou plusieurs aimants permanents ou électro-aimants (3, 3') présente un composant de champ orienté perpendiculairement à l'axe optique du faisceau laser (5) et/ou au plan dans lequel le faisceau laser (5) est dévié.

3. Agencement selon la revendication 1 ou 2, **caractérisé en ce qu'**un premier diaphragme (1) est agencé entre le ou les aimants permanents ou électro-aimants (3, 3') et la fenêtre, au travers de l'ouverture duquel le faisceau laser (5) est orienté vers la ou les cibles (6).

4. Agencement selon l'une quelconque des revendications précédentes, **caractérisé en ce qu'**un aimant permanent ou un électro-aimant (3) est agencé sur un côté de l'axe optique et un second aimant permanent ou électro-aimant (3') sur un côté opposé de l'axe optique du faisceau laser (5).

5. Agencement selon la revendication 4, **caractérisé en ce que** les aimants permanents ou électro-aimants (3, 3') présentent la même orientation de polarisation.

6. Agencement selon l'une quelconque des revendications précédentes, **caractérisé en ce qu'**un élément (9) raccordé à un potentiel électrique positif est agencé sur un côté agencé en opposition au au moins un aimant permanent ou électro-aimant (3) par rapport à l'axe optique et/ou au plan dans lequel le faisceau laser (5) est dévié.

7. Agencement selon la revendication 6, **caractérisé en ce qu'**un champ qui est orienté parallèlement à l'axe longitudinal de l'anode (7) est formé avec l'aimant permanent ou l'électro-aimant (3).

8. Agencement selon la revendication 6 ou 7, **caractérisé en ce que** l'élément (9) est en forme de plaque, de bande, de grille ou muni de bandes, et dans lequel l'élément (9) est orienté parallèlement à l'axe optique du faisceau laser (5) et/ou au plan dans lequel le faisceau laser (5) est dévié.

9. Agencement selon l'une quelconque des revendications précédentes, **caractérisé en ce que** les aimants permanents ou les électro-aimants (3, 3') sont agencés selon un agencement décalé entre la fenêtre et la cible (6).

10. Agencement selon l'une quelconque des revendications précédentes, **caractérisé en ce que** deux aimants permanents ou électro-aimants (3, 3') forment un diaphragme.

11. Agencement selon l'une quelconque des revendications précédentes, **caractérisé en ce que** le ou les aimants permanents ou électro-aimants (3, 3') présentent une largeur qui correspond au moins à la longueur de la ou des cibles (6).

12. Agencement selon l'une quelconque des revendications précédentes, **caractérisé en ce qu'**un ou plusieurs aimants permanents ou électro-aimants (3, 3') sont agencés entre deux diaphragmes (1, 2).

13. Agencement selon l'une quelconque des revendications précédentes, **caractérisé en ce qu'**un film de protection de fenêtre (4) est agencé entre le premier diaphragme (1) et la fenêtre.

14. Agencement selon la revendication précédente, **caractérisé en ce que** le film de protection de fenêtre (4) est enroulable et déroulable au moyen d'un mécanisme.
